# EUROPEAN PATENT APPLICATION

(11) **EP 2 843 717 A1**
(43) Date of publication of application: **04.03.2015**
(21) Application number: 14002905.9
(22) Date of filing: 21.08.2014
(51) Int. Cl.: H01L 33/50, F21K 99/00, H01L 33/48

(54) **PHOSPHOR FILM, AND LIGHT EMITTING DEVICE AND SYSTEM USING THE SAME**

(30) Priority: 27.08.2013 KR 20130101887
(71) Applicant: Industry-Academic Cooperation Foundation Yonsei University, Seoul (KR)
(72) Inventor: Kim, Young Joo, Gyeonggi-do (KR); Hong, Hyun Guk, Gyeongsangnam-do (KR); Shin, Min Ho, Gyeongsangbuk-do (KR); Kim, Hyo Jun, Seoul (KR)
(74) Representative: Zeitler - Volpert - Kandlbinder

(57) **Abstract**

Phosphor film, and light emitting device and system using the same are provided. The light emitting device comprises a package body (10), a light emitting element (20) disposed on the package body (10) to generate first light, one or more first quantum dot phosphor layers (62) formed above the light emitting element (20) to perform wavelength conversion of the first light and generate second light, and one or more second quantum dot phosphor layers (64) formed above the light emitting element (20) so as not to overlap with the first quantum dot phosphor layers (62) to perform wavelength conversion of the first light and generate third light different from the second light.

## Description

### CROSS-REFERENCE TO RELATED APPLICATION

This application claims priority from Korean Patent Application No. 10-2013-0101887 filed on August 27, 2013 in the Korean Intellectual Property Office, the disclosure of which is incorporated herein in its entirety by reference.

### BACKGROUND

### 1. Technical Field

The present inventive concept relates to a phosphor film, and a light emitting device and system using the same.

### 2. Description of the Related Art

A light emitting element such as a light emitting diode (LED) emits light by combination of electrons and holes. The light emitting element has a low power consumption and a long life, and can be installed even in a narrow space. Also, the light emitting element is resistant to vibration.

A light emitting device can generate light of various wavelengths, for example, blue light, UV light, and white light, according to a manufacturing method.

For example, a method of manufacturing a white light emitting device capable of generating white light will be described as an example. The white light emitting device for generating white light may be manufactured by coating yellow phosphors on a blue light emitting element which generates blue light. Alternatively, white light may be generated by additionally using red phosphors as well as the yellow phosphors.

The phosphors absorb light generated by the light emitting element, perform wavelength conversion of the light, and emit the wavelength-converted light. However, the phosphors may emit the light in all directions without emitting the light in a specific direction. Thus, the light emitted backward is likely to be lost, and a light extraction rate may be reduced.

Further, the light generated by the light emitting element may be lost by being absorbed by the inner sidewall of a package. Further, although the light generated by the light emitting element is reflected by the inner sidewall of the package, an optical path becomes longer, and the light extraction rate may be reduced.

### SUMMARY

An aspect of the present invention provides a phosphor film capable of improving a light extraction rate.

Another aspect of the present invention provides a light emitting device including the phosphor film.

Still another aspect of the present invention provides a light emitting system including the light emitting device.

However, aspects of the present invention are not restricted to the one set forth herein. The above and other aspects of the present invention will become more apparent to one of ordinary skill in the art to which the present invention pertains by referencing the detailed description of the present invention given below.

According to an aspect of the present invention, there is provided a light emitting device comprising: a package body; a light emitting element disposed on the package body to generate first light; one or more first quantum dot phosphor layers formed above the light emitting element to perform wavelength conversion of the first light and generate second light; and one or more second quantum dot phosphor layers formed above the light emitting element so as not to overlap with the first quantum dot phosphor layers to perform wavelength conversion of the first light and generate third light different from the second light.

According to another aspect of the present invention, there is provided a light emitting device comprising: a package body including a slot; a light emitting element disposed in the slot to generate first light; a lens formed in the slot to surround at least a portion of the light emitting element, the lens having a longitudinal length longer than a transverse length; a phosphor film including first quantum dot phosphor layers and second quantum dot phosphor layers formed in a mesh shape above the light emitting element; and an air gap formed in the slot and disposed between the lens and the phosphor film.

### BRIEF DESCRIPTION OF THE DRAWINGS

The above and other aspects and features of the present invention will become more apparent by describing in detail exemplary embodiments thereof with reference to the attached drawings, in which:
FIG. 1 is a diagram for explaining a phosphor film according to a first embodiment of the present invention;
FIG. 2 is a diagram for explaining a phosphor film according to a second embodiment of the present invention;
FIG. 3 is a diagram for explaining a phosphor film according to a third embodiment of the present invention;
FIG. 4 is a diagram for explaining a phosphor film according to a fourth embodiment of the present invention;
FIG. 5 is a diagram for explaining a phosphor film according to a fifth embodiment of the present invention;
FIG. 6 is a cross-sectional view for explaining a light emitting device according to a first embodiment of the present invention;
FIG. 7A is a cross-sectional view for explaining a light emitting device according to a second embodiment of the present invention;
FIG. 7B is a diagram for explaining an operation and effect of the light emitting device of FIG. 7A;
FIG. 8 is a perspective view of a light emitting device according to some embodiments of the present invention;
FIGS. 9 to 11 are exemplary cross-sectional views taken along line A-A' of FIG. 8.
FIG. 12 is a diagram for explaining a light emitting system according to a first embodiment of the present invention; and
FIGS. 13 to 16 are diagrams for explaining light emitting systems according to second to fifth embodiments of the present invention.

### DETAILED DESCRIPTION OF THE EMBODIMENTS

The present invention will now be described more fully hereinafter with reference to the accompanying drawings, in which preferred embodiments of the invention are shown. This invention may, however, be embodied in different forms and should not be construed as limited to the embodiments set forth herein. Rather, these embodiments are provided so that this disclosure will be thorough and complete, and will filly(□fully) convey the scope of the invention to those skilled in the art. The same reference numbers indicate the same components throughout the specification. In the attached figures, the thickness of layers and regions is exaggerated for clarity.

It will be understood that when an element or layer is referred to as being "connected to," or "coupled to" another element or layer, it can be directly connected to or coupled to another element or layer or intervening elements or layers may be present. In contrast, when an element is referred to as being "directly connected to" or "directly coupled to" another element or layer, there are no intervening elements or layers present. Like numbers refer to like elements throughout. As used herein, the term "and/or" includes any and all combinations of one or more of the associated listed items.

It will be understood that, although the terms first, second, etc. may be used herein to describe various elements, these elements should not be limited by these terms. These terms are only used to distinguish one element from another element. Thus, for example, a first element, a first component or a first section discussed below could be termed a second element, a second component or a second section without departing from the teachings of the present invention.

The use of the terms "a" and "an" and "the" and similar referents in the context of describing the invention (especially in the context of the following claims) are to be construed to cover both the singular and the plural, unless otherwise indicated herein or clearly contradicted by context. The terms "comprising," "having," "including," and "containing" are to be construed as open-ended terms (i.e., meaning "including, but not limited to,") unless otherwise noted.

Unless defined otherwise, all technical and scientific terms used herein have the same meaning as commonly understood by one of ordinary skill in the art to which this invention belongs. It is noted that the use of any and all examples, or exemplary terms provided herein is intended merely to better illuminate the invention and is not a limitation on the scope of the invention unless otherwise specified. Further, unless defined otherwise, all terms defined in generally used dictionaries may not be overly interpreted.

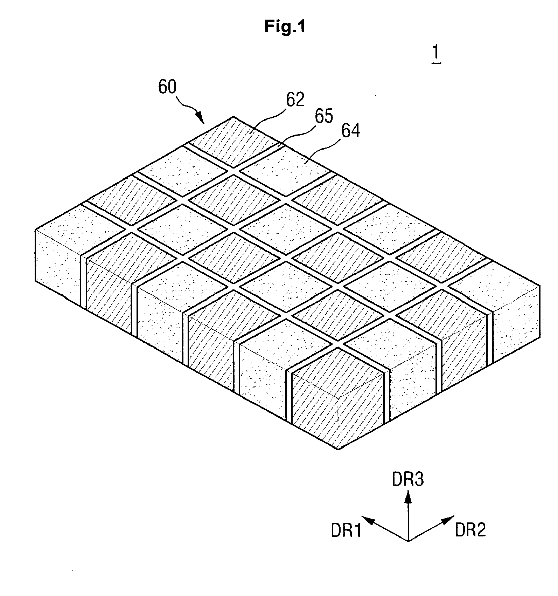

FIG. 1 is a diagram for explaining a phosphor film according to a first embodiment of the present invention.

Referring to FIG. 1, a phosphor film 60 according to the first embodiment of the present invention includes one or more first quantum dot phosphor layers 62, one or more second quantum dot phosphor layers 64 and an adhesive layer 65.

The first quantum dot phosphor layers 62 may be formed to be spaced apart from each other. The first quantum dot phosphor layers 62 include resin and first quantum dot phosphors. That is, the first quantum dot phosphor layers 62 may include resin and first quantum dot phosphors dispersed in the resin. The resin in which the first quantum dot phosphors are dispersed may include, for example, epoxy resin, silicone resin, rigid silicone resin, modified silicone resin, urethane resin, oxetane resin, acrylic resin, polycarbonate resin, polyimide resin, or the like, but it is not limited thereto. That is, the resin may be any material capable of stably dispersing the first quantum dot phosphors.

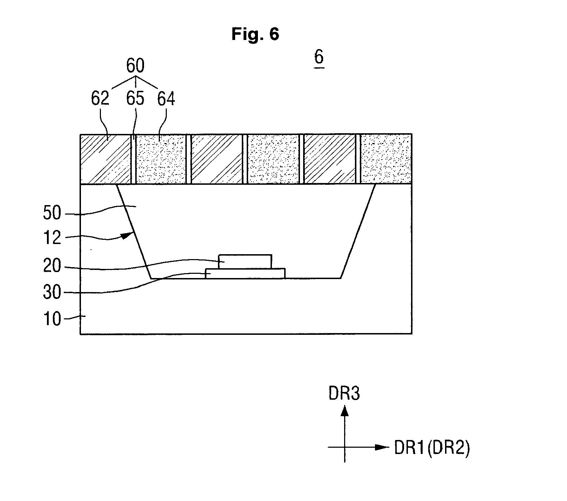

The second quantum dot phosphor layers 64 may be formed to be spaced apart from each other. The second quantum dot phosphor layers 64 may be formed so as not to overlap with the first quantum dot phosphor layers 62. Similarly to the first quantum dot phosphor layers 62, the second quantum dot phosphor layers 64 may include resin and second quantum dot phosphors, which are dispersed in the resin. The first quantum dot phosphors and the second quantum dot phosphors respectively included in the first quantum dot phosphor layers 62 and the second quantum dot phosphor layers 64 may generate light of different wavelengths, and a description thereof will be described with reference to FIG. 6.

The adhesive layer 65 may physically connect the first quantum dot phosphor layers 62 with the second quantum dot phosphor layers 64. That is, the adhesive layer 65 may prevent the first quantum dot phosphor layers 62 and the second quantum dot phosphor layers 64 from being separated from each other in the phosphor film 60 in which the first quantum dot phosphor layers 62 and the second quantum dot phosphor layers 64 are configured as a single film.

The adhesive layer 65 may be formed between the first quantum dot phosphor layers 62 and the second quantum dot phosphor layers 64 which do not overlap with each other. The adhesive layer 65 may be formed on at least a portion of the circumstance of each of the first quantum dot phosphor layers 62 and the second quantum dot phosphor layers 64. The adhesive layer 65 may include, for example, epoxy resin, silicone resin, rigid silicone resin, modified silicone resin, urethane resin, oxetane resin, acrylic resin, polycarbonate resin, polyimide resin, or the like. Further, taking into consideration an adhesive force between the adhesive layer 65 and the first quantum dot phosphor layers 62 and between the adhesive layer 65 and the second quantum dot phosphor layers 64, the adhesive layer 65 may include the same resin as the resin included in the first quantum dot phosphor layers 62 and the second quantum dot phosphor layers 64.

Considering a fill factor of the phosphor film 60 including the first quantum dot phosphor layers 62 and the second quantum dot phosphor layers 64, the width of the adhesive layer 65, i.e., the area of the adhesive layer 65, may be adjusted.

An exemplary configuration of the first quantum dot phosphors and the second quantum dot phosphors included in the first quantum dot phosphor layers 62 and the second quantum dot phosphor layers 64 may be as follows. The quantum dot phosphor may include a core consisting of semiconductor particles, such as CdSe, CdTe and InP of the groups II-IV, III-V or the like, having a size of 2 ∼ 10 nm, and a shell mainly consisting of ZnS and the like. Further, the quantum dot phosphor may be coated with an inorganic material (SiO₂), polymer or the like to have a thickness of about 10 ∼ 15 nm. The quantum dot phosphor absorbs light of a short wavelength from the outside and emits light of a long wavelength in the same manner as a general phosphor. However, the quantum dot phosphor may emit light in a frequency range from the frequency of blue light to the frequency of red light according to the sizes of the particles due to a quantum confinement effect although it has the same composition as a general phosphor. If the sizes of the quantum dots are suitably adjusted (or combined), it is easy to implement a white LED with high color rendering property. In addition, since the quantum dot phosphors are nanoparticles, a long-life operation can be performed, and optical stability and thermal stability are excellent.

As examples of the quantum dot phosphors that can be used to implement white light, there are ZnSe, CdSe, InGaP and the like. Many studies have been conducted mainly on CdSe quantum dots capable of covering the visible light spectrum. For example, CdSe quantum dots emitting green light have conversion efficiency of 70 to 80% in blue and purple LEDs, CdSe quantum dots emitting purple light have conversion efficiency of 70% in purple LEDs, and InGaP quantum dots emitting purple light have conversion efficiency of 50% in purple LEDs.

The quantum dot phosphor has a narrow full width at half maximum(FWHM) and a wide range of available wavelengths. Even if a small amount of quantum dot phosphors are used, the quantum dot phosphors may complement general phosphors. For example, it is possible to adjust the color temperature and color rendering index of a white LED by mixing a small amount of quantum dot phosphors with YAG phosphors.

In the phosphor film according to the first embodiment of the present invention, the first quantum dot phosphor layers 62 and the second quantum dot phosphor layers 64 may be arranged in a mesh shape.

Further, in the phosphor film according to the first embodiment of the present invention, the first quantum dot phosphor layers 62 and the second quantum dot phosphor layers 64 may be formed alternately. That is, the first quantum dot phosphor layers 62 may be adjacent to the second quantum dot phosphor layers 64 in a first direction DR1 and a second direction DR2. However, it is not limited thereto, and the first quantum dot phosphor layers 62 and the second quantum dot phosphor layers 64 may be arranged considering a color rendering index (CRI).

Although a case where the adhesive layer 65 is interposed between the first quantum dot phosphor layers 62 and the second quantum dot phosphor layers 64 has been illustrated in FIG. 1, the present invention is not limited thereto. That is, the first quantum dot phosphor layers 62 may be directly in contact with and connected to the second quantum dot phosphor layers 64 without the adhesive layer 65 between the first quantum dot phosphor layers 62 and the second quantum dot phosphor layers 64.

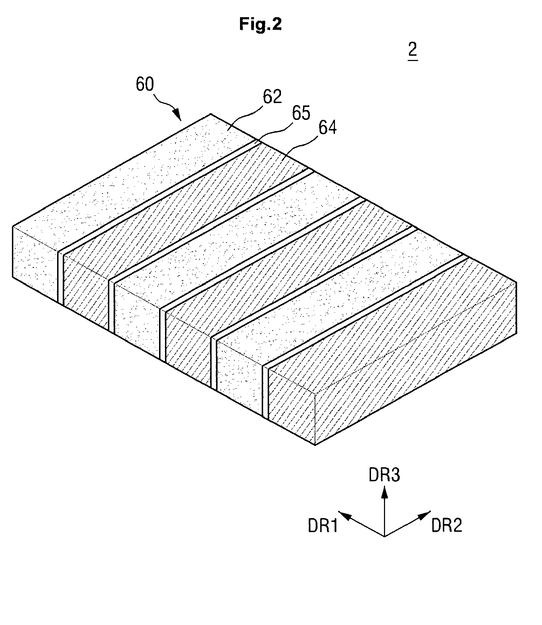

FIG. 2 is a diagram for explaining a phosphor film according to a second embodiment of the present invention. Since the second embodiment is substantially the same as the first embodiment except for a pattern shape of the first quantum dot phosphors and the second quantum dot phosphors, differences are mainly described.

Referring to FIG. 2, a phosphor film 60 according to the second embodiment of the present invention includes one or more first quantum dot phosphor layers 62, one or more second quantum dot phosphor layers 64 and an adhesive layer 65.

In the phosphor film according to the second embodiment of the present invention, each of the first quantum dot phosphor layers 62 and the second quantum dot phosphor layers 64 has a linear shape. That is, each of the first quantum dot phosphor layers 62 and the second quantum dot phosphor layers 64 may extend in the second direction DR2. Also, the adhesive layer 65 may extend in the second direction DR2 and may be formed on at least a portion of the circumstance of each of the first quantum dot phosphor layers 62 and the second quantum dot phosphor layers 64.

Further, in the phosphor film according to the second embodiment of the present invention, the first quantum dot phosphor layers 62 and the second quantum dot phosphor layers 64 may be formed alternately. Unlike the configuration shown in FIG. 2, the first quantum dot phosphor layers 62 may be in direct contact with the second quantum dot phosphor layers 64.

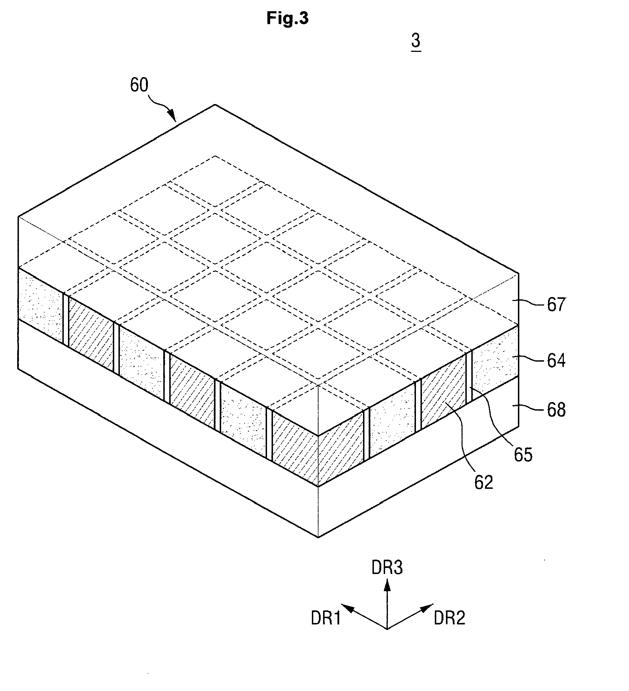

FIG. 3 is a diagram for explaining a phosphor film according to a third embodiment of the present invention. The third embodiment may further include a transparent substrate in the phosphor film according to the first embodiment and the second embodiment. For simplicity of description, a case where a transparent substrate is added to the phosphor film of FIG. 1 will be described, but it is not limited thereto.

Referring to FIG. 3, a phosphor film 60 according to the third embodiment of the present invention includes one or more first quantum dot phosphor layers 62, one or more second quantum dot phosphor layers 64, an adhesive layer 65, a first transparent substrate 67 and a second transparent substrate 68.

The first transparent substrate 67 is formed on the first quantum dot phosphor layers 62 and the second quantum dot phosphor layers 64. The second transparent substrate 68 is formed below the first quantum dot phosphor layers 62 and the second quantum dot phosphor layers 64. That is, the first transparent substrate 67 and the second transparent substrate 68 face each other while the first quantum dot phosphor layers 62 and the second quantum dot phosphor layers 64 are interposed therebetween.

Each of the first transparent substrate 67 and the second transparent substrate 68 may be a transparent substrate capable of transmitting light. Each of the first transparent substrate 67 and the second transparent substrate 68 may be, for example, a rigid substrate such as a ceramic substrate, a quartz substrate and a glass substrate for display, or a flexible plastic substrate made of polyimide, polyethylene terephthalate (PET), polyethylene naphthalate (PEN), polymethyl methacrylate (PMMA), polycarbonate (PC), polyether sulfone (PES), polyester or the like, but it is not limited thereto.

A method of manufacturing a phosphor film will be described with reference to FIGS. 1 and 3.

The first quantum dot phosphor layers 62 are formed on the first transparent substrate 67. Specifically, a first quantum dot film for forming the first quantum dot phosphor layers 62 is formed on the first transparent substrate 67. Then, imprinting is performed by using a first mold with a pattern for forming the first quantum dot phosphor layers 62, thereby forming the first quantum dot phosphor layers 62 on the first transparent substrate 67.

Further, the second quantum dot phosphor layers 64 are formed on the second transparent substrate 68. Specifically, a second quantum dot film for forming the second quantum dot phosphor layers 64 is formed on the second transparent substrate 68. Then, imprinting is performed by using a second mold with a pattern for forming the second quantum dot phosphor layers 64, thereby forming the second quantum dot phosphor layers 64 on the second transparent substrate 68.

In this case, the pattern formed in the first mold the pattern formed in the second mold may be complementary to each other.

Subsequently, the first transparent substrate 67 on which the first quantum dot phosphor layers 62 are formed is bonded to the second transparent substrate 68 on which the second quantum dot phosphor layers 64 are formed. Accordingly, the phosphor film 60 shown in FIG. 3 may be manufactured.

Additionally, each of the first transparent substrate 67 and the second transparent substrate 68 may be separated from the first quantum dot phosphor layers 62, the second quantum dot phosphor layers 64 and the adhesive layer 65. In this case, the phosphor film 60 shown in FIG. 1 may be manufactured.

In the case where the pattern of the first mold and the pattern of the second mold are formed differently, the phosphor film 60 having linear arrangement as shown in FIG. 2 may be manufactured.

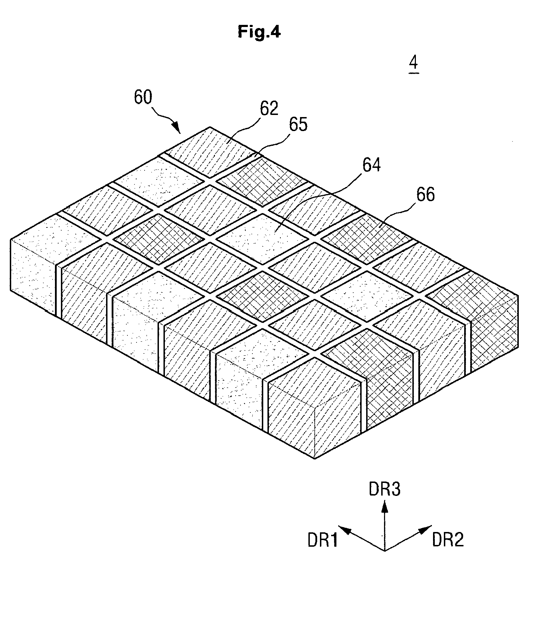

FIG. 4 is a diagram for explaining a phosphor film according to a fourth embodiment of the present invention.

Referring to FIG. 4, a phosphor film 60 according to the fourth embodiment of the present invention includes one or more first quantum dot phosphor layers 62, one or more second quantum dot phosphor layers 64, one or more third quantum dot phosphor layers 66, and an adhesive layer 65.

The first quantum dot phosphors, the second quantum dot phosphors and the third quantum dot phosphors respectively included in the first quantum dot phosphor layers 62, the second quantum dot phosphor layers 64 and the third quantum dot phosphor layers 66 may generate light of different wavelengths.

In the phosphor film according to the fourth embodiment of the present invention, the first quantum dot phosphor layers 62, the second quantum dot phosphor layers 64 and the third quantum dot phosphor layers 66 may be arranged in a mesh shape. The adhesive layer 65 may be formed on the circumstance of each of the first quantum dot phosphor layers 62, the second quantum dot phosphor layers 64 and the third quantum dot phosphor layers 66.

The arrangement of the first quantum dot phosphor layers 62, the second quantum dot phosphor layers 64 and the third quantum dot phosphor layers 66 shown in FIG. 4 is merely an exemplary arrangement for explanation, but it is not limited thereto.

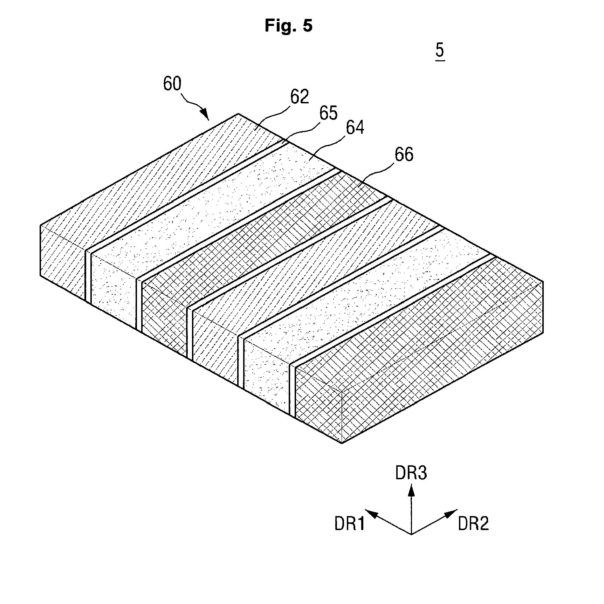

FIG. 5 is a diagram for explaining a phosphor film according to a fifth embodiment of the present invention.

Referring to FIG. 5, a phosphor film 60 according to the fifth embodiment of the present invention includes first quantum dot phosphor layers 62, second quantum dot phosphor layers 64 and third quantum dot phosphor layers 66, which have a linear shape and are formed alternately.

FIG. 6 is a cross-sectional view for explaining a light emitting device 6 according to a first embodiment of the present invention. For simplicity of description, only main parts are simplified or emphasized in FIG. 6.

Referring to FIG. 6, the light emitting device 6 according to the first embodiment of the present invention may include a package body 10, a light emitting element 20, a submount 30, a resin layer 50 and a phosphor film 60.

The light emitting element 20 may be disposed on the package body 10. Specifically, the package body 10 may include a slot 12 therein, and the light emitting element 20 may be disposed in the slot 12 and connected to the slot 12. In particular, the sidewall of the slot 12 may be inclined. The light generated in the light emitting element 20 may be reflected by the sidewall to move forward.

Further, a case where the light emitting element 20 is connected to the submount 30 and the light emitting element 20 connected to the submount 30 is disposed in the slot 12 of the package body 10 is illustrated in the drawing, but the present invention is not limited thereto. That is, the light emitting element 20 may be installed directly on the package body 10 without using the submount 30.

The light emitting element 20 generates first light. The light emitting element 20 may be a light emitting diode (LED), but it is not limited thereto. Although not clearly shown, the light emitting element 20 may include a first conductive layer of a first conductivity type (e.g., n-type), a second conductive layer of a second conductivity type (e.g., p-type), a light emitting layer disposed between the first conductive layer and the second conductive layer, a first electrode connected to the first conductive layer, and a second electrode connected to the second conductive layer. If a forward driving bias is applied to the light emitting element 20, carriers (i.e., electrons) of the first conductive layer and carriers (i.e., holes) of the second conductive layer meet and combine in the light emitting layer to generate light. The first conductive layer, the second conductive layer and the light emitting layer may be formed of InₓAl_{y}Ga_{(1-x-y)}N (0≤x≤1, 0≤y≤1).

The light emitting element 20 may be operated by the driving bias applied between the first electrode and the second electrode. The driving bias is an absolute value of a difference between a first bias applied to the first electrode and a second bias applied to the second electrode. In this case, the driving bias may be DC power or AC power.

Although not clearly shown, the light emitting element 20 may be a flip chip type LED, a lateral type LED, or a vertical type LED.

Further, the light emitting element 20 may be a blue light emitting element to generate blue light (i.e., light in a blue wavelength range), and a UV light emitting element to generate UV light.

The light emitting element 20 is disposed in the slot 12 of the package body 10, and the slot 12 is larger than the light emitting element 20. It is preferable to determine the size of the slot 12 considering the amount and angle of reflection at which light generated in the light emitting element 20 is reflected by the sidewall of the slot 12, the type of the resin layer 50 filled in the slot 12, the type of the phosphor film 60 and the like. Further, it is preferable to place the light emitting element 20 at the center of the slot 12. If the distance between the light emitting element 20 and the sidewall is constant, it is easy to prevent the nonuniformity of the chromaticity.

The package body 10 may be made of an organic material having excellent light resistance, such as silicone resin, epoxy resin, acrylic resin, urea resin, fluorine resin and imide resin, or an inorganic material having excellent light resistance, such as glass and silica gel. Further, in order to prevent the resin from being melted due to heat generated during a manufacturing process, thermosetting resin may be used. Further, in order to alleviate the thermal stress of the resin, various fillers such as aluminum nitride, aluminum oxide and complex mixtures thereof may be mixed therein. Further, the package body 10 is not limited to the resin. A metal material or ceramic material may be used for a part (e.g., sidewall) or all of the package body 10. For example, if the package body 10 is formed entirely of a metal material, the heat generated in the light emitting element 20 can be easily emitted to the outside.

The resin layer 50 may be coated on the light emitting element 20. Specifically, the resin layer 50 may be filled in at least a portion of the slot 12. Although a case where the resin layer 50 is completely filled in the slot 12 has been illustrated in the drawing, the present invention is not limited thereto.

The material of the resin layer 50 is not particularly limited as long as it can be filled in the slot 12 of the package body 10. For example, the resin layer 50 may be formed of resin such as epoxy resin, silicone resin, rigid silicone resin, modified silicone resin, urethane resin, oxetane resin, acrylic resin, polycarbonate resin and polyimide resin.

The phosphor film 60 may be formed on the light emitting element 20. The phosphor film 60 includes the first quantum dot phosphor layers 62 and the second quantum dot phosphor layers 64 not overlapping with the first quantum dot phosphor layers 62. The first quantum dot phosphor layers 62 and the second quantum dot phosphor layers 64 are formed above the light emitting element 20.

The first quantum dot phosphor layers 62 and the second quantum dot phosphor layers 64 may be arranged at substantially the same height from the bottom surface of the slot 12. The first quantum dot phosphor layers 62 and the second quantum dot phosphor layers 64 may be arranged adjacent to each other in the first direction DR1 or the second direction DR2 which is a direction other than a third direction DR3.

The first quantum dot phosphor layers 62 performs wavelength conversion of the first light generated by the light emitting element 20 to generate second light. The second quantum dot phosphor layers 64 performs wavelength conversion of the first light generated by the light emitting element 20 to generate third light different from the second light. Assuming that the wavelength of the second light is longer than the wavelength of the third light, the first quantum dot phosphor layers 62 may perform wavelength conversion of the third light reflected by the slot to generate second light.

If the phosphor film 60 includes the first quantum dot phosphor layers 62 and the second quantum dot phosphor layers 64, the first quantum dot phosphor layers 62 may include red quantum dot phosphors to generate red light, and the second quantum dot phosphor layers 64 may include green quantum dot phosphors to generate green light.

Alternatively, the first quantum dot phosphor layers 62 may include yellow quantum dot phosphors to generate yellow light, and the second quantum dot phosphor layers 64 may include blue quantum dot phosphors to generate blue light.

By adjusting the sizes of the first quantum dot phosphor layers 62 and the second quantum dot phosphor layers 64 and the concentrations of the quantum dot phosphors respectively included in the first quantum dot phosphor layers 62 and the second quantum dot phosphor layers 64, it is possible to adjust the color conversion, color temperature and color rendering property.

In the light emitting device according to the first embodiment of the present invention, the phosphor film 60 may be the phosphor film which has been described with reference to FIG. 1 or FIG. 2, but it is not limited thereto.

Hereinafter, improvement of a light extraction rate by forming the first quantum dot phosphor layers 62 and the second quantum dot phosphor layers 64 in a two-dimensional pattern in the phosphor film 60 will be described.

The first light generated in the light emitting element 20 passes through the resin layer 50 and is incident on the phosphor film 60. The first light incident on the phosphor film 60 is wavelength-converted into the second light and the third light by the first quantum dot phosphor layers 62 and the second quantum dot phosphor layers 64, respectively.

Assuming that the wavelength of the second light is longer than the wavelength of the third light, a part of the third light may be reabsorbed into the first quantum dot phosphor layers 62 and wavelength-converted into the second light. In this case, the conversion efficiency when the third light is wavelength-converted into the second light is lower than the conversion efficiency when the first light is directly wavelength-converted into the second light. This is because two wavelength conversions result in a greater reduction in conversion efficiency than one wavelength conversion. The reduction in conversion efficiency leads to a decrease in light extraction rate of the light emitting device.

However, since the first quantum dot phosphor layers 62 and the second quantum dot phosphor layers 64 are formed adjacent to each other in the first direction DR1 or the second direction DR2, a re-absorption rate of the third light into the first quantum dot phosphor layers 62 is lower than that when the first quantum dot phosphor layers 62 and the second quantum dot phosphor layers 64 are arranged in the third direction DR3. Thus, the re-absorption rate of the third light generated by the second quantum dot phosphor layers 64 into the first quantum dot phosphor layers 62 is reduced, thereby improving the light extraction rate of the light emitting device.

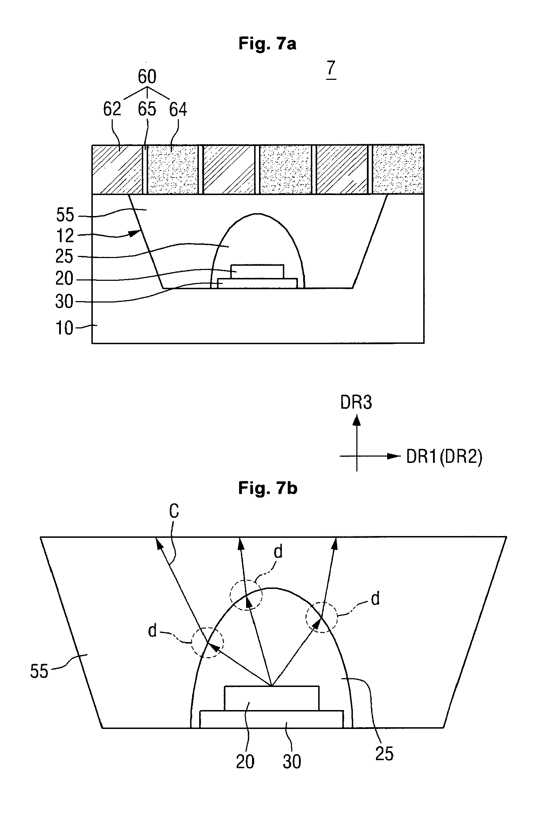

FIG. 7A is a cross-sectional view for explaining a light emitting device according to a second embodiment of the present invention. FIG. 7B is a diagram for explaining an operation and effect of the light emitting device of FIG. 7A. This embodiment will be described focusing on differences from the embodiment described with reference to FIG. 6.

Referring to FIGS. 7A and 7B, a light emitting device 7 according to the second embodiment of the present invention may include a package body 10, a light emitting element 20, a lens 25, a submount 30, an air gap 55 and a phosphor film 60.

The lens 25 may be formed in the slot 12 to surround at least a portion of the light emitting element 20. The lens 25 may be manufactured by using, for example, a polymer, but it is not limited thereto. As illustrated, the lens 25 may have a longitudinal length (i.e., length in the third direction DR3) longer than a transverse length (i.e., length in the first direction DR1 or the second direction DR2).

As described with reference to FIGS. 1 and 2, the phosphor film 60 may be formed by alternately arranging the first quantum dot phosphor layers 62 and the second quantum dot phosphor layers 64. Further, the first quantum dot phosphor layers 62 and the second quantum dot phosphor layers 64 may be formed in a mesh or linear shape.

The first quantum dot phosphor layers 62 perform wavelength conversion of the first light generated by the light emitting element 20 to generate the second light. The second quantum dot phosphor layers 64 perform wavelength conversion of the first light generated by the light emitting element 20 to generate the third light.

The air gap 55 may be formed in the slot 12, and disposed between the lens 25 and the phosphor film 60. That is, the air gap 55 may be disposed between the lens 25 and the first quantum dot phosphor layers 62 and between the lens 25 and the second quantum dot phosphor layers 64.

By providing the lens 25 and the air gap 55 in the light emitting device 7, the first light generated from the light emitting element 20 may move forward without being diffused in all directions. Specifically, since the lens 25 has a longitudinal length longer than a transverse length and there is a difference in refractive index between the lens 25 and the air gap 55, the first light may move forward (see c of FIG. 7B) from the boundary (see d of FIG. 7B) between the lens 25 and the air gap 55.

That is, since the first light can move forward, it is possible to minimize the probability that the first light is incident on the inner sidewall of the package body 10. That is, it is possible to minimize a loss that may occur when the first light is incident on the inner sidewall of the package body 10. By adjusting an exit angle of the first light generated from the light emitting element 20, light extraction efficiency can be increased.

Further, in the case where the light emitting element 20 and the air gap 55 are in direct contact with each other, the extraction efficiency of the light emitting element 20 may be reduced. However, in the light emitting device 7 according to the second embodiment of the present invention, since the light emitting element 20 is in direct contact with the lens 25, the extraction efficiency can be increased compared to a case where the light emitting element 20 is in direct contact with the air gap 55. The Fresnel loss may be minimized through a design of the lens 25.

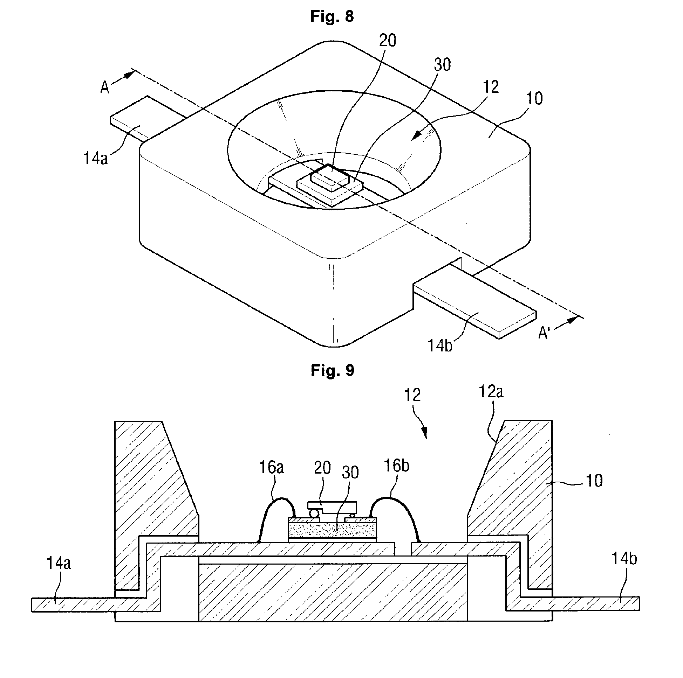

FIGS. 8 to 11 are exemplary diagrams showing a light emitting device according to some embodiments of the present invention, which is implemented as packages.

FIG. 8 is a perspective view of a light emitting device according to some embodiments of the present invention. FIGS. 9 to 11 are exemplary cross-sectional views taken along line A-A' of FIG. 8.

First, referring to FIGS. 8 and 9, the light emitting element 20 may be mounted on the submount 30, and the submount 30 may be disposed on the package body 10. Further, leads 14a and 14b electrically connected to the light emitting element 20 are installed on the package body 10. The light emitting element 20 may be electrically connected to the submount 30, and the submount 30 may be connected to the leads 14a and 14b through, for example, wires 16a and 16b. Meanwhile, the leads 14a and 14b are formed preferably by using a material with high thermal conductivity such that the heat generated in the light emitting element 20 can be discharged directly to the outside through the leads 14a and 14b.

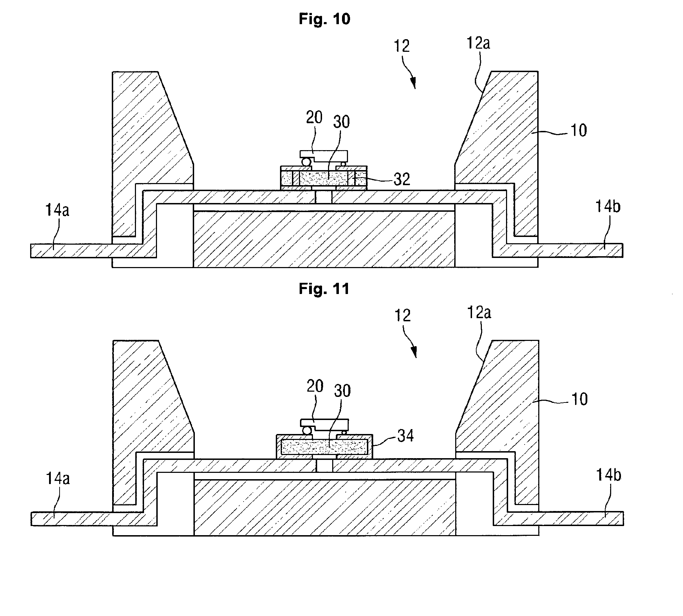

Meanwhile, the light emitting device shown in FIG. 10 is different from the light emitting device shown in FIG. 9 in that the submount 30 is connected to the leads 14a and 14b through vias 32 provided in the submount 30 without using the wires 16a and 16b of FIG. 9.

Further, the light emitting device shown in FIG. 11 is different from the light emitting device shown in FIG. 9 in that the submount 30 is connected to the leads 14a and 14b through an interconnection 34 provided along the upper, side and rear surfaces of the submount 30 without using the wires 16a and 16b of FIG. 9.

Since the light emitting device of FIG. 10 and the light emitting device of FIG. 11 do not use wires, the size of the light emitting device can be reduced.

Hereinafter, light emitting systems manufactured by using the aforementioned light emitting devices 6 and 7 will be described. The following description will be given using the light emitting device 7 according to the second embodiment of the present invention as an example, but it is obvious that the light emitting device 6 according to some other embodiments may be applied.

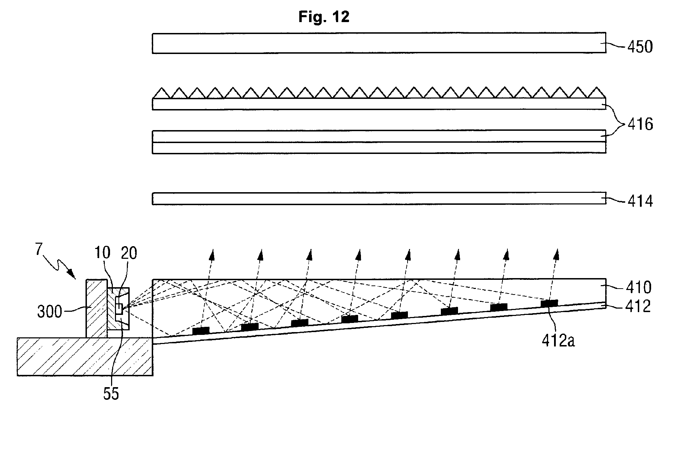

FIG. 12 is a diagram for explaining a light emitting system according to a first embodiment of the present invention.

The light emitting system shown in FIG. 12 is an exemplary system (end product) to which, e.g., the light emitting device 7 of the present invention is applied. The light emitting system may be applied to a variety of devices such as an illumination device, a display device and a mobile device (a cellular phone, an MP3 player, a navigation device, etc.). The exemplary system shown in FIG. 12 is an edge-type backlight unit (BLU) used for a liquid crystal display (LCD). Since the LCD is not a self-emitting device, the backlight unit is used a light source, and the backlight unit illuminates the LCD mainly from the backside of a liquid crystal panel.

Referring to FIG. 12, the backlight unit includes the light emitting device 7, a light guiding plate 410, a reflection plate 412, a diffusion sheet 414, and a pair of prism sheets 416.

The light emitting device 7 serves to supply light. As described above, the light emitting device 7 may comprise the phosphor film 60 including first quantum dot phosphor layers 62 and the second quantum dot phosphor layers 64, and the like.

The light guiding plate 410 serves to guide the light to be supplied to a liquid crystal panel 450. The light guiding plate 410 may be formed as a panel made of a plastic-based transparent material such as acrylic, and allows the light generated from the light emitting device 7 to travel toward to the liquid crystal panel 450 disposed above the light guiding plate 410. Accordingly, various patterns 412a for changing the traveling direction of light incident into the light guiding plate 410 to a direction toward the liquid crystal panel 450 are printed on the rear surface of the light guiding plate 410.

The reflection plate 412 is provided on the lower surface of the light guiding plate 410 to reflect the light emitted downward from the light guiding plate 410 in an upward direction. The reflection plate 412 reflects the light that is not reflected by the patterns 412a formed on the rear surface of the light guiding plate 410 toward an exit surface of the light guiding plate 410, thereby reducing an optical loss and enhancing uniformity of light transmitted to the exit surface of the light guiding plate 410.

The diffusion sheet 414 diffuses the light emitted from the light guiding plate 410 to prevent the light from being partially concentrated.

The prism sheets 416 may include triangular prisms formed on the top surface in a predetermined arrangement. Generally, the prism sheets 416 may consist of two sheets including prisms alternately arranged at a predetermined angle to allow the light diffused by the diffusion sheet 414 to travel in a direction perpendicular to the liquid crystal panel 450.

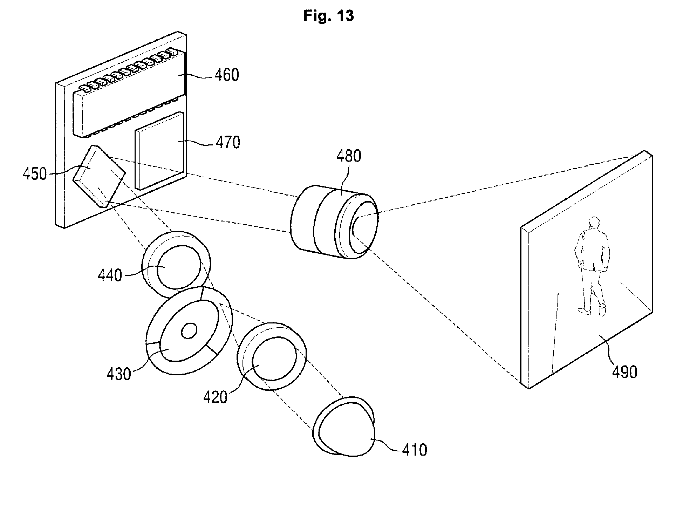

FIGS. 13 to 16 are diagrams for explaining light emitting systems according to second to fifth embodiments of the present invention.

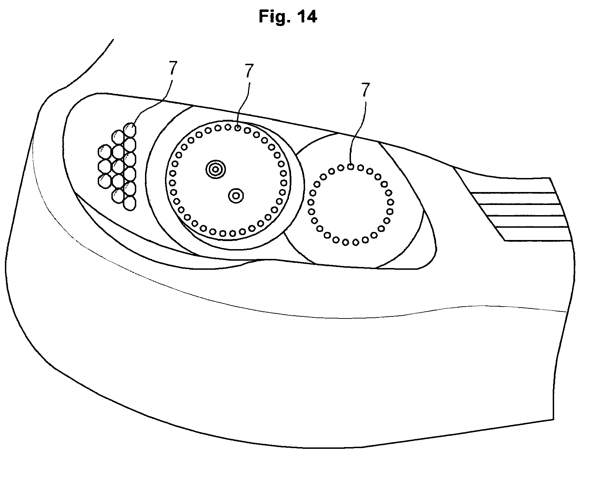

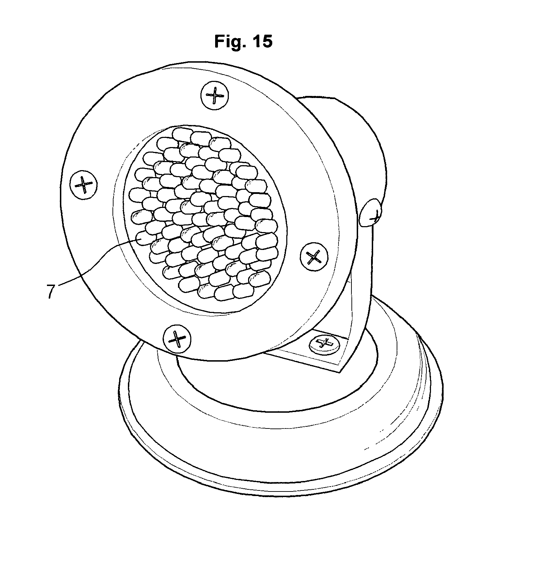

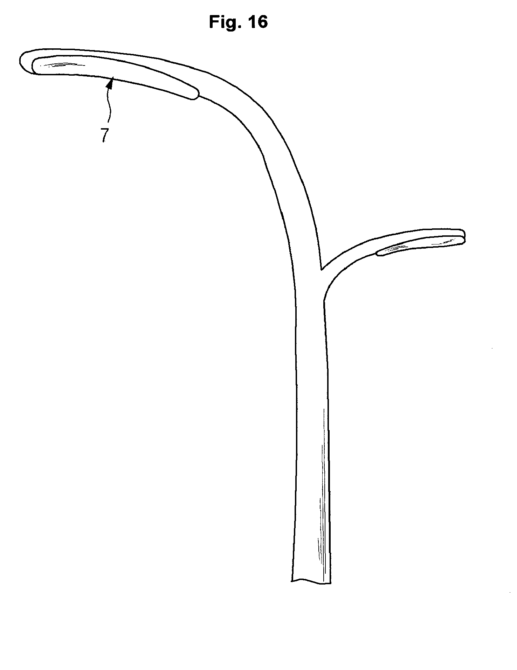

FIG. 13 illustrates a projector, FIG. 14 illustrates a headlight of an automobile, FIG. 15 illustrates an illumination lamp, and FIG. 16 illustrates a street lamp. Referring to FIG. 13, the light emitted from a light source 410 passes through a condensing lens 420, a color filter 430, and a sharping lens 440, and is reflected by a digital micromirror device (DMD) 450. Then, the reflected light passes through a projection lens 480 to reach a screen 490. The light emitting device of the present invention may be provided in the light source 410.

In concluding the detailed description, those skilled in the art will appreciate that many variations and modifications can be made to the preferred embodiments without substantially departing from the principles of the present invention. Therefore, the disclosed preferred embodiments of the invention are used in a generic and descriptive sense only and not for purposes of limitation.

## Claims

1. A light emitting device comprising:
a package body;
a light emitting element disposed on the package body to generate first light;
one or more first quantum dot phosphor layers formed above the light emitting element to perform wavelength conversion of the first light and generate second light; and
one or more second quantum dot phosphor layers formed above the light emitting element so as not to overlap with the first quantum dot phosphor layers to perform wavelength conversion of the first light and generate third light different from the second light.

2. The light emitting device of claim 1, wherein each of the first quantum dot phosphor layers and the second quantum dot phosphor layers has a linear shape, and
wherein the first quantum dot phosphor layers and the second quantum dot phosphor layers are formed alternately.

3. The light emitting device of claim 1, wherein the first quantum dot phosphor layers and the second quantum dot phosphor layers are formed in a mesh shape.

4. The light emitting device of claim 1, wherein the package body includes a slot, and the light emitting element is formed in the slot.

5. The light emitting device of claim 4, further comprising a lens formed in the slot to surround at least a portion of the light emitting element.

6. The light emitting device of claim 5, further comprising an air gap formed in the slot and disposed between the lens and the first quantum dot phosphor layers and between the lens and the second quantum dot phosphor layers.

7. The light emitting device of claim 5, wherein the lens includes a polymer.

8. The light emitting device of claim 5, wherein the lens has a longitudinal length longer than a transverse length.

9. The light emitting device of claim 4, further comprising a resin layer formed in the slot to cover the light emitting element.

10. A light emitting device comprising:
a package body including a slot;
a light emitting element disposed in the slot to generate first light;
a lens formed in the slot to surround at least a portion of the light emitting element, the lens having a longitudinal length longer than a transverse length;
a phosphor film including first quantum dot phosphor layers and second quantum dot phosphor layers formed in a mesh shape above the light emitting element; and
an air gap formed in the slot and disposed between the lens and the phosphor film.

11. The light emitting device of claim 10, wherein the first quantum dot phosphor layers perform wavelength conversion of the first light to generate second light, and the second quantum dot phosphor layers perform wavelength conversion of the first light to generate third light different from the second light.

12. The light emitting device of claim 11, wherein the first quantum dot phosphor layers and the second quantum dot phosphor layers are formed alternately.

13. The light emitting device of claim 11, wherein the first quantum dot phosphor layers include red quantum dot phosphors, and the second quantum dot phosphor layers include green quantum dot phosphors.
